# FASCICULE DE BREVET EUROPEEN

(11) **EP 2 741 188 B1**
(45) Date de publication et mention de la délivrance du brevet: **23.08.2017**
(21) Numéro de dépôt: 13194352.4
(22) Date de dépôt: 26.11.2013
(51) Int. Cl.: G06F 3/044, G06F 3/041

(54) **Dispositif tactile multitouches à détection capacitive multifréquence et barycentrique**
Berührungsempfindliche Multitouch-Vorrichtung zur kapazitiven Multifrequenz- und Schwerpunkt-Erkennung
Multi-touch tactile device with multifrequency, barycentric, capacitive detection

(30) Priorité: 05.12.2012 FR 1203298
(43) Date de publication de la demande: 11.06.2014
(73) Titulaire: Thales, 92400 Courbevoie (FR)
(72) Inventeur: Coni, Philippe, 33127 Saint Jean d'Illac (FR); Rouzes, Siegfried, 33185 Le Haillan (FR)
(74) Mandataire: Bréda, Jean-Marc

(56) Documents cités:
- EP-A2- 2 196 889
- CONI P., PERBET J.N., SONTAG Y., ABADIE J.C.: "Eliminating Ghost Touches on a Self-Capacitive Touch-Screen", SID SYMPOSIUM DIGEST OF TECHNICAL PAPERS, vol. 43, juin 2012 (2012-06), pages 411-414, XP002703949, DOI: 10.1002/j.2168-0159.2012.tb05803.x

## Description

Le domaine de l'invention est celui des surfaces tactiles ou « touchscreen » à détection capacitive et plus particulièrement des surfaces tactiles dites multitouches ou « multitouch » permettant la détection de deux appuis simultanés. Cette fonction est essentielle pour réaliser par exemple des « zooms » ou des rotations d'image. Cette invention peut s'appliquer dans différentes utilisations mais elle est particulièrement bien adaptée aux contraintes du domaine aéronautique et des planches de bord d'aéronef.

La détection capacitive dite « projetée » consiste à réaliser une matrice de détection agencée de façon à détecter les variations locales de capacité introduites par la proximité des doigts de l'utilisateur ou de tout autre objet de désignation conducteur. La technologie dite capacitive projetée se décline en deux variantes principales qui sont :
- Détection « Self capacitive » qui consiste à lire les lignes puis les colonnes du réseau de touches de la matrice ;
- Détection dite « Mutual capacitive » consistant à lire chaque intersection du réseau de touches de la matrice ;

La technologie « Mutual capacitive » nécessite la lecture de toute la dalle. Ainsi, si la matrice comporte N lignes et M colonnes, il faut réaliser N x M acquisitions, rendant problématique la réalisation de dalles de grande taille, de haute résolution et à faible temps de réponse. De plus, la capacité à mesurer en « Mutual capacitance » est plus faible que celle obtenue en « Self capacitive », ce qui rend problématique l'usage de gants par l'utilisateur.

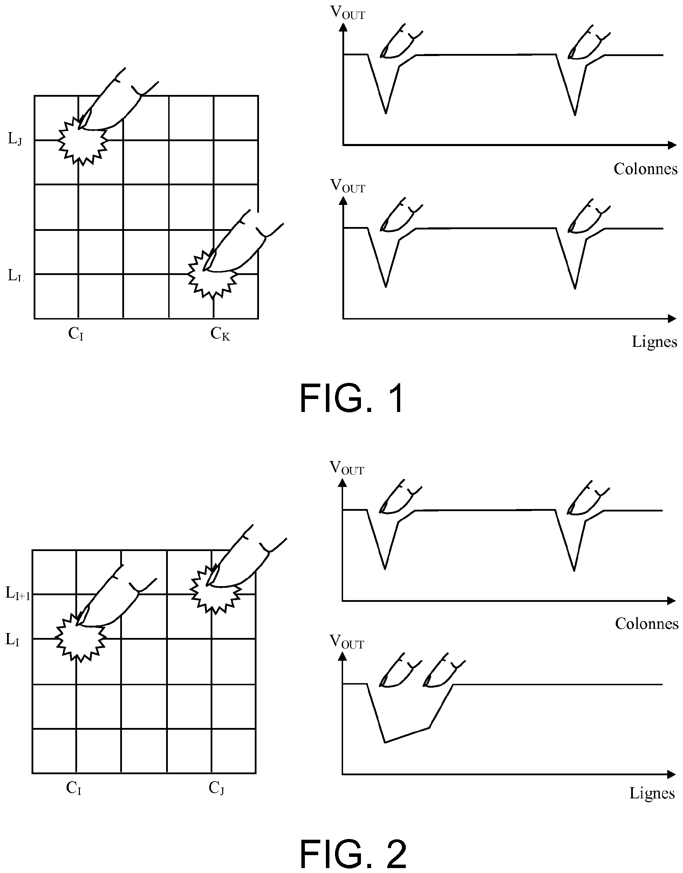

L'avantage de la détection « Self capacitive » est que, pour la dalle précédente, le système nécessite uniquement N+M acquisitions pour réaliser une lecture de la matrice. La figure 1 illustre ce principe. Sur cette figure 1, un premier doigt appuie au niveau d'une première intersection de la colonne C_{I} et de la ligne L_{J} et un second doigt appuie au niveau d'une seconde intersection de la colonne C_{K} et de la ligne L_{L}. Les tensions de sortie V_{OUT} des lignes et des colonnes présentent des baisses de niveau facilement identifiables. Les mesures des tensions autour de chaque baisse de niveau permettent d'identifier précisément les lignes et les colonnes sollicitées.

Cependant, cette dernière technique présente un inconvénient. Il n'est pas toujours simple d'attribuer les lignes et les colonnes détectées aux bonnes intersections réellement touchées par les doigts de l'utilisateur. Les intersections possibles mais non réellement touchées sont généralement appelées « ghosts ». Pour contrer cette difficulté, une technique consiste à réaliser un balayage de la matrice à deux fréquences d'acquisition différentes. Cette technique est décrite dans la publication « Eliminating Ghost Touches on a Self-Capacitive Touch-Screen » parue dans « SID 2012 DIGEST » de juin 2012.

Pour bien comprendre cette technique, il faut utiliser des modèles électroniques de représentation d'un dispositif matriciel capacitif. Il existe un modèle simplifié pour décrire électriquement un dispositif tactile capacitif comportant une matrice d'électrodes composée de lignes et de colonnes conductrices. Il consiste en une représentation de l'appui où le doigt de l'opérateur se couple capacitivement à la matrice en projetant la surface de son doigt sur la dalle. Cette surface recouvre au moins deux électrodes, une première en ligne et une seconde en colonne. On considère alors que l'opérateur rapporte une capacité C_{d} entre la terre et au moins la ligne ou la colonne concernée. Mais ce modèle reste local et ne tient pas compte de l'environnement de la mesure.

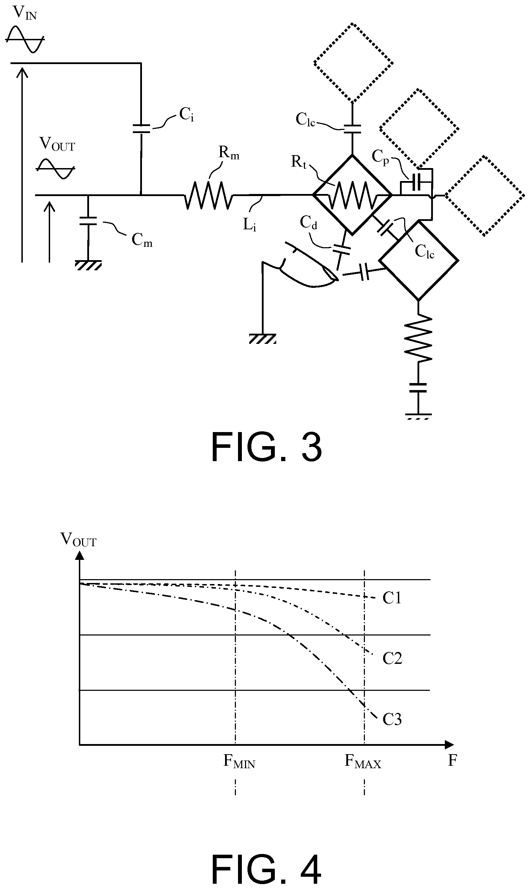

La figure 3 représente un modèle plus élaboré d'un dispositif matriciel capacitif. Chaque ligne est en fait connectée à un dispositif de mesure et/ou d'alimentation au travers de switchs analogiques. Ces switchs apportent une capacité de couplage Cₘ par rapport à la masse et présentent une résistance électrique Rₘ provoquant une atténuation du signal mesuré.

De plus, chaque ligne étant constituée d'un matériau transparent de type ITO (Indium Tin Oxide) qui présente une certaine résistance entre le point d'alimentation et le point de contact du doigt, cette résistance étant d'autant plus élevée que le doigt est éloigné du point de connexion. Si Rₜ est la résistance d'une touche et de sa connexion à la suivante, alors la résistance entre l'appui sur la colonne n et le bord de la matrice est de n.Rₜ.

D'autre part, le réseau de lignes et colonnes est mutuellement couplé. En effet, il existe une capacité Cₚ à chaque croisement de pistes, chaque ligne étant coupée par n colonne et d'autre part, les lignes ou colonne se couplent avec leurs voisines. Ce couplage est représenté sur la figure 3 par une capacité C_{Ic}. Enfin, il existe également des capacités de couplage entre la dalle tactile, sa connectique et les pièces mécaniques constituant le dispositif, ainsi qu'un couplage mutuel entre les différentes pistes reliant les lignes et les colonnes au dispositif électronique de mesure.

Par conséquent, l'acquisition d'une dalle tactile capacitive ne peut se réduire à l'acquisition d'une simple capacité projetée par un opérateur. Elle est le résultat de cette projection sur un composant complexe multipolaire composé d'une association de résistances et de capacités interconnectées entre elles.

Le dispositif « Self capacitive bi-fréquence » exploite cette complexité. Comme on le voit sur la figure 3, en l'absence d'objet au voisinage de la matrice, chaque ligne Lᵢ est reliée à une alimentation en tension alternative au travers d'une capacité d'injection Ci et à un buffer de lecture qui possède une impédance d'entrée constituée d'une capacité de couplage parasite par rapport à la masse Cₘ et une résistance d'entrée Rₘ. Cette ligne Lᵢ possède une résistance linéique et se trouve couplée capacitivement à chaque croisement de colonne.

Lorsqu'un doigt se pose sur un point précis de la ligne Lᵢ, il projette une capacité sur la portion de la ligne considérée. Les dispositifs tactiles selon l'art antérieur mesurent uniquement cette capacité projetée. Cette simple mesure ne permet pas de connaître la position de l'appui sur la ligne, cette information n'étant pas portée par la valeur de la capacité projetée.

Le coeur du dispositif est de ne pas considérer simplement la capacité rapportée, mais son effet sur le modèle complexe que constitue la ligne entière. En particulier, si l'on considère la résistance Rᵢₗ de la ligne Lᵢ de longueur l, alors il existe une résistance Rᵢₐ entre une extrémité de la ligne et le point de contact. La résistance Rᵢₐ est inférieure à Rᵢₗ. Cette valeur de résistance modifie le signal de sortie V_{OUT}. Ce signal V_{OUT} vaut :
V_{OUT} = Z.V_{IN} avec V_{IN} : signal d'entrée périodique de fréquence F et Z : impédance de la ligne qui vaut :
   Z=A+Bj Les termes A et B étant des fonctions des capacités Cₘ, Ci et C_{d} et des résistances Rₘ et Rᵢₐ.

La topologie du modèle s'assimile au premier ordre à un réseau RC ou la résistance Rᵢₐ associée à la capacité C_{d} constitue un filtre passe bas de premier ordre. La figure 4 représente, en fonction de la fréquence appliquée, la variation du signal de sortie d'une ligne pour trois positions d'appui différentes, la première courbe C1 pour un appui situé en bord de ligne, la seconde C2 pour un appui en milieu de ligne, la troisième courbe C3 pour un appui en fin de ligne. L'échelle de la figure 4 est logarithmique sur les deux axes. Il existe alors, comme on le voit sur la figure 4 une fréquence F_{MIN} telle que les variations de Rᵢₐ provoquent une variation minimale de V_{OUT} quelque soit la position de l'appui. A l'inverse, il existe une fréquence F_{MAX} telle que les variations de Rᵢₐ provoquent une atténuation importante de V_{OUT} en fonction de la position de l'appui. Ainsi, à cette fréquence F_{MAX}, en mesurant cette atténuation, il est alors facile de connaître la valeur de la résistance Rᵢₐ et par conséquent, de déterminer la position du point de contact sur la ligne.

Cette mesure n'est pas nécessairement très précise. Elle est cependant suffisante pour déterminer la position réelle de deux appuis simultanés. Connaissant, même approximativement, par la double mesure à deux fréquences différentes, les positions des appuis, l'indétermination entre le couple d'appuis réels et le couple d'appuis fantôme ou « ghosts » qui lui correspond est levé.

Il existe cependant encore certaines configurations pouvant engendrer soit une incertitude sur la position des doigts de l'utilisateur soit une erreur de positionnement. Une de ces configurations se produit lorsque deux doigts touchent deux lignes ou deux colonnes voisines. Cette configuration est illustrée en figure 2. Sur cette figure, le premier doigt appuie au niveau d'une première intersection de la colonne C_{I} et de la ligne L_{I} et un second doigt appuie au niveau d'une seconde intersection de la colonne C_{J} et de la ligne L_{I+1}. La tension de sortie V_{OUT} des colonnes présentent deux pics facilement identifiables permettant de déterminer qu'il y a eu appui sur les colonnes C_{I} et Cⱼ. Par contre, la tension de sortie V_{OUT} des lignes présentent une forme en créneau ne permettant pas d'identifier clairement les lignes concernées, même en utilisant des calculs barycentriques de tension.

Le dispositif tactile selon l'invention ne présente pas ces inconvénients. Son principe physique repose sur l'utilisation de tensions d'émission à deux fréquences différentes. On a démontré que les signaux de sortie sur les lignes sur les colonnes ont, en fonction de la fréquence, des impédances différentes représentatives non seulement de la présence d'un appui sur une ligne et une colonne mais encore de sa position sur cette ligne et cette colonne.

Ce dispositif est totalement « dual touch », il est insensible au bruit de lecture et aux perturbations électromagnétiques extérieures et enfin, il est compatible des normes d'émission électromagnétique telles que celles spécifiées en aéronautique. De plus, l'utilisateur peut utiliser cette surface tactile avec les mains gantées avec le même niveau de performance.

Plus précisément, l'invention a pour objet un dispositif à écran tactile à détection capacitive projetée tel que revendiqué dans la revendication 1. Avantageusement, lorsque la première ligne est au voisinage de la seconde ligne ou lorsque la première colonne et au voisinage de la seconde colonne de façon que les deux variations de tension correspondant aux deux lignes proches ou aux deux colonnes proches forment un seul et unique creux, la localisation des deux appuis est effectuée au moyen :
Des premiers moyens d'analyse permettant de repérer le « creux » des tensions de réception pour la première fréquence et le « creux » des tensions de réception pour la seconde fréquence correspondant aux variations de tension des deux appuis sur les deux lignes voisines ou sur les deux colonnes voisines ;
De seconds moyens d'analyse permettant de calculer les barycentres des deux « creux » de tension ;
De troisièmes moyens d'analyse permettant de déterminer à partir de la connaissance desdits deux barycentres la première ligne et la seconde ligne voisines ou la première colonne et la seconde colonne voisines correspondant au premier appui ou au second appui.

Avantageusement, les moyens de réception et d'analyse électroniques des tensions de réception comportent deux démodulateurs synchrones, le premier démodulateur travaillant à la fréquence de travail, le second démodulateur à la fréquence de discrimination.

Avantageusement, les moyens de réception et d'analyse électroniques comportent :
- une table des valeurs stockées des tensions de réception à la fréquence de travail de chaque ligne et de chaque colonne en l'absence d'appui ;
- des moyens de comparaison établissant, pour chaque ligne et pour chaque colonne, les écarts entre les valeurs mesurées des tensions de réception et les valeurs stockées des tensions de réception de façon à déterminer si les écarts mesurés sont représentatifs d'un appui sur la ligne ou sur la colonne concernée.

Avantageusement, la fréquence de travail est comprise entre 100 kHz et 500 kHz et la fréquence de discrimination est comprise entre 500 kHz et 5 MHz.

L'invention sera mieux comprise et d'autres avantages apparaîtront à la lecture de la description qui va suivre donnée à titre non limitatif et grâce aux figures annexées parmi lesquelles :
La figure 1 déjà commentée représente le principe de détection capacitive de deux appuis simultanés ;
La figure 2 déjà commentée représente le problème de la détection capacitive de deux appuis sur deux lignes ou deux colonnes voisines ;
La figure 3 déjà commentée représente le schéma électrique des capacités et des résistances électriques autour d'un croisement entre une ligne et une colonne d'une dalle tactile ;
La figure 4 déjà commentée représente, pour deux fréquences différentes, les variations du signal de sortie d'une ligne ou d'une colonne en fonction de la position de l'appui dans un dispositif tactile ;
La figure 5 représente le synoptique d'un dispositif tactile capacitif projeté selon l'invention ;
La figure 6 représente le principe de la détection et de l'identification de deux appuis sur deux lignes ou deux colonnes voisines.

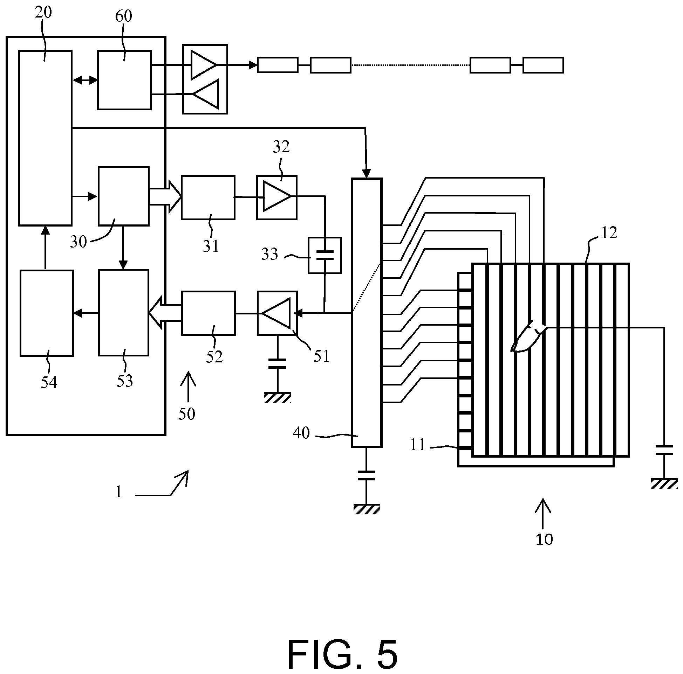

A titre d'exemple non limitatif, la figure 5 représente un dispositif 1 à dalle tactile à détection capacitive projetée selon l'invention. Il comprend essentiellement :
- une dalle tactile 10 comprenant un premier substrat comportant une première série de lignes conductrices 11 parallèles entre elles et un second substrat comportant une seconde série de colonnes 12 conductrices parallèles entre elles ;
- des moyens de commande et d'analyse 20 des différents signaux d'émission et de réception nécessaires au fonctionnement du dispositif tactile ;
- Un générateur 30 haute fréquence sinusoïdal à fréquence variable alimentant la dalle tactile en tensions alternatives V_{IN} par l'intermédiaire d'un convertisseur numérique-analogique « DAC » 31, d'un amplificateur 32 et d'une capacité d'injection 33. Typiquement, les fréquences sont comprises entre quelques centaines de KHz et quelques MHz ;
- Un multiplexeur 40. Il applique la tension d'entrée V_{IN} successivement à chaque colonne 12 puis à chaque ligne 11 de la dalle tactile 10 et dirige chaque tension de sortie V_{OUT} correspondant à une tension V_{IN} appliquée vers une chaîne de traitement électronique 50 ;
- Une chaîne de traitement électronique 50 qui comprend une mémoire-tampon ou « buffer » 51, un convertisseur analogique-numérique ou ADC 52, un démodulateur synchrone 53 relié au générateur de fréquences 30 et des moyens électroniques de filtrage 54. Les signaux filtrés sont envoyés aux moyens d'analyse 20 ;
- Des moyens d'émission-réception 60 ou « UART » signifiant « Universal Asynchronous Receiver Transmitter » qui assure la retransmission des signaux traités par les moyens d'analyse 20 vers l'extérieur qui est généralement un dispositif de visualisation couplé avec la dalle tactile et qui affiche des informations que l'on souhaite commander, modifier ou valider.

Le fonctionnement du dispositif est le suivant. En mode nominal, les lignes et les colonnes de la dalle sont balayées en permanence et successivement par une tension d'entrée V_{IN} à une première fréquence de travail F_{MIN} et à une seconde fréquence dite de discrimination F_{MAX}. Cette tension est générée par l'ensemble électronique composé des moyens 30, 31, 32 et 33.

Lors d'un appui représenté symboliquement par un doigt sur la figure 5 et suivant la position de cet appui, il se crée une certaine capacité entre le point de contact et la masse, cette capacité étant principalement relié par une résistance de lignes et de colonnes au multiplexeur 40.

Cette composante résistive et capacitive va provoquer une variation de l'impédance totale Z du système, et agir sur le signal de sortie V_{OUT} qui vaut, comme on l'a dit, Z.V_{IN} avec Z=A+Bj. Le signal V_{OUT} est ensuite démodulé par la chaîne électronique 50 afin d'en extraire la valeur efficace V_{OUT}=Z.V_{IN}, avec Z=A+Bj et j=sin(2π.F.t) au moyen d'un démodulateur synchrone 53. La démodulation synchrone permet de filtrer les perturbations électromagnétiques de type « EMI » en agissant comme un filtre passe bande à facteur de qualité élevé, ce qui évite l'emploi de filtrages passifs peu sélectifs.

Deux mesures au moins sont effectuées, une à la fréquence de travail F_{MIN}, et une à la fréquence de discrimination F_{MAX}. On peut, pour des dalles de dimension importante, utiliser plusieurs fréquences de discrimination F_{MAX}. Avantageusement, les fréquences F_{MIN} et F_{MAX} sont modulées et démodulées séparément au moyen de deux démodulateurs synchrones 53, ce qui permet d'obtenir en une seule mesure les valeurs de la capacité C et de la résistance R, représentatives de la position de l'appui. Enfin, le signal continu filtré issu du démodulateur 53 est filtré au moyen du filtrage 54.

En l'absence d'approche de la main, le contrôleur tactile effectue en permanence une image de la dalle à la fréquence F_{MIN} et en déduit une table au repos des impédances par moyenne glissante. Cette image est soustraite à la table des valeurs instantanées des impédances, pour former la table des écarts, à partir de laquelle il est possible d'attribuer à chaque point de croisement son statut. Cette méthode est en partie décrite dans le brevet EP 0 567 364 intitulé « Process for operating a capacitive tactile keyboard ».

L'utilisation de deux fréquences de mesure différentes a un avantage important. En cas d'appuis multiples non alignés, le quadruplet de points est mesuré à la fréquence F_{MIN}, puis à la fréquence F_{MAX}. La variation du signal consécutive à la variation de fréquence est utilisée pour déterminer la rejection des appuis fantômes et le quadruplet de points permet de donner les coordonnées des différents appuis.

Pour obtenir plus de précisions sur la position des appuis, la localisation des appuis est effectuée au moyen :
De premiers moyens d'analyse permettant de repérer les « creux » des tensions de réception pour la fréquence de travail et les « creux » des tensions de réception pour la fréquence de discrimination correspondant aux variations de tension des appuis ;
De seconds moyens d'analyse permettant de calculer les barycentres des « creux » de tension ;
De troisièmes moyens d'analyse permettant de déterminer, à partir de la connaissance des barycentres, les lignes et les colonnes correspondant aux différents appuis.

A titre d'exemple, la détermination du barycentre est effectuée de la façon suivante. On détermine les minima ou « creux » des tensions de réception V_{OUT.} Un minimum correspond à une ligne ou à une colonne particulière. Dans la suite de ce paragraphe, pour simplifier, on choisit de s'intéresser uniquement aux minima des tensions de réception des lignes. Bien entendu, le procédé vaut pour les colonnes. Autour d'une ligne L_{MIN} correspondant à un minimum, on calcule pour un nombre déterminé de lignes situées de part et d'autre de cette ligne L_{MIN} le barycentre desdites lignes, chaque ligne étant affecté d'un coefficient égal à la valeur de la tension de sortie de ladite ligne. Ce barycentre correspond à la position du point d'appui. On peut bien entendu affiner la méthode en déterminant, par exemple, les pentes de tension entourant un minimum de tension.

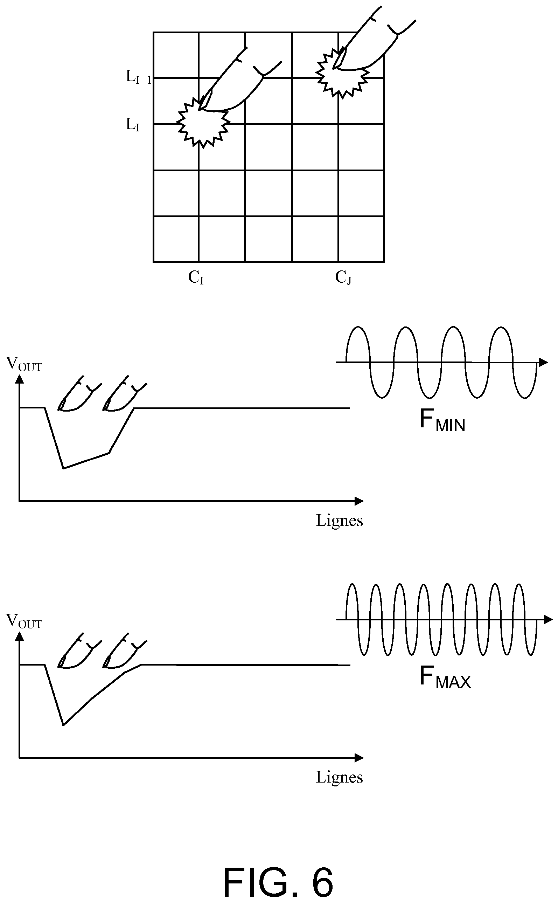

La méthode barycentrique permet d'améliorer la précision de position des appuis. Elle a un autre avantage lorsqu'elle est couplée à la mesure à deux fréquences différentes. En effet, comme illustré en figure 6, lorsque, dans le cas de deux appuis simultanés, le premier appui situé à un premier croisement d'une première ligne et d'une première colonne et le second appui situé à un second croisement d'une seconde ligne et d'une seconde colonne et lorsque la première ligne est au voisinage de la seconde ligne ou lorsque la première colonne et au voisinage de la seconde colonne de façon que les deux variations de tension correspondant aux deux lignes proches ou aux deux colonnes proches comportent un seul et unique creux de tension, il est possible de déterminer précisément les lignes et les colonnes sollicitées. En effet, comme on le voit sur la figure 6, à la fréquence de travail, la tension de réception correspondant aux deux appuis situés, par exemple, sur deux lignes voisines L_{I} et L_{I+1}, donnera un seul creux de tension ne permettant pas de déterminer simplement les lignes sollicitées. On peut seulement déterminer le barycentre des deux appuis. Par contre, à la fréquence de discrimination, le creux de tension correspondant à un des deux appuis s'atténue. Il ne subsiste plus qu'un seul creux de tension permettant de déterminer sans ambiguïté la première ligne, par exemple L_{I}, correspondant à un des deux appuis. Il devient alors facile, connaissant la position barycentrique de ce premier appui et la position barycentrique des deux appuis réunis, de déterminer la seconde ligne L_{I+1} correspondant au second appui.

Comme on le voit, les moyens électroniques mis en oeuvre dans le dispositif tactile selon l'invention sont simples et permettent de résoudre efficacement les principaux problèmes de la détection capacitive projetée, c'est-à-dire la détection des appuis fantômes, la détection des appuis proches, l'insensibilité aux perturbations électromagnétiques externes due à la détection synchrone et l'absence de perturbations de l'environnement électronique par l'utilisation de signaux sinusoïdaux purs et sans harmoniques.

## Revendications

1. Dispositif à écran tactile (1) à détection capacitive projetée comprenant une dalle tactile (10) matricielle comportant une pluralité de lignes conductrices (11) et de colonnes conductrices (12), ladite dalle étant reliée à des moyens de commande électroniques (20) générant, pour chaque ligne et pour chaque colonne conductrice, des tensions d'émission (V_{IN}) et reliée à des moyens de réception et d'analyse électroniques (50) des tensions de réception (V_{OUT}) issues de chaque ligne et de chaque colonne conductrice, les moyens de commande électroniques étant adaptés pour générer, pour chaque ligne et pour chaque colonne conductrice, une première tension d'émission périodique émise à une première fréquence (F_{MIN}) notée fréquence de travail et une seconde tension d'émission périodique émise à une seconde fréquence (F_{MAX}) notée fréquence de discrimination, différente de la première fréquence, de sorte que: en présence d'appui, la valeur faible de la fréquence de travail provoque de très faibles variations des tensions de réception à cette fréquence de travail et la valeur élevée de la fréquence de discrimination provoque des variations significatives des tensions de réception en fonction de la position de l'appui sur la ligne ou sur la colonne à cette fréquence de discrimination ;
les moyens de réception et d'analyse électroniques (50) étant agencés de façon à déterminer, pour chaque ligne et pour chaque colonne :
- La valeur d'une première tension de réception à la fréquence de travail et la valeur d'une seconde tension de réception à la fréquence de discrimination ;
- Si, en fonction de valeurs prédéterminées, les valeurs des deux tensions de réception sont représentatives de deux appuis simultanés sur la dalle tactile et la localisation de ces deux appuis sur les deux lignes et sur les deux colonnes concernées ;
**caractérisé en ce que**, dans le cas de deux appuis simultanés, le premier appui situé à un premier croisement d'une première ligne et d'une première colonne et le second appui situé à un second croisement d'une seconde ligne et d'une seconde colonne, la localisation des deux appuis est effectuée au moyen :
De premiers moyens d'analyse permettant de repérer les minima ou « creux » des tensions de réception pour la première fréquence et les minima ou « creux » des tensions de réception pour la seconde fréquence correspondant aux variations de tension des deux appuis ;
De seconds moyens d'analyse permettant de calculer, autour de chaque ligne ou de chaque colonne correspondant à un desdits minima, pour un nombre déterminé de lignes ou de colonnes situées de part et d'autre de cette ligne ou de cette colonne, le barycentre du « creux » de tension ;
De troisièmes moyens d'analyse permettant de déterminer, à partir de la connaissance des barycentres, la première ligne et la première colonne correspondant au premier appui et la seconde ligne et la seconde colonne correspondant au second appui.

2. Dispositif à écran tactile selon la revendication 1, **caractérisé en ce que**, lorsque la première ligne est au voisinage de la seconde ligne ou lorsque la première colonne et au voisinage de la seconde colonne de façon que les deux variations de tension correspondant aux deux lignes proches ou aux deux colonnes proches forment un seul et unique creux, la localisation des deux appuis est effectuée au moyen :
Des premiers moyens d'analyse permettant de repérer le « creux » des tensions de réception pour la première fréquence et le « creux » des tensions de réception pour la seconde fréquence correspondant aux variations de tension des deux appuis sur les deux lignes voisines ou sur les deux colonnes voisines ;
De seconds moyens d'analyse permettant de calculer les barycentres des deux « creux » de tension ;
De troisièmes moyens d'analyse permettant de déterminer à partir de la connaissance desdits deux barycentres la première ligne et la seconde ligne voisines ou la première colonne et la seconde colonne voisine correspondant au premier appui ou au second appui.

3. Dispositif à écran tactile selon l'une des revendications précédentes, **caractérisé en ce que** les moyens de réception et d'analyse électroniques des tensions de réception comportent deux démodulateurs synchrones (53), le premier démodulateur travaillant à la fréquence de travail, le second démodulateur à la fréquence de discrimination.

4. Dispositif à écran tactile selon l'une des revendications précédentes, **caractérisé en ce que** les moyens de réception et d'analyse électroniques comportent :
- une table des valeurs stockées des tensions de réception à la fréquence de travail de chaque ligne et de chaque colonne en l'absence d'appui ;
- des moyens de comparaison établissant, pour chaque ligne et pour chaque colonne, les écarts entre les valeurs mesurées des tensions de réception et les valeurs stockées des tensions de réception de façon à déterminer si les écarts mesurés sont représentatifs d'un appui sur la ligne ou sur la colonne concernée.

5. Dispositif à écran tactile selon l'une des revendications précédentes, **caractérisé en ce que** la fréquence de travail est comprise entre 100 kHz et 500 kHz et **en ce que** la fréquence de discrimination est comprise entre 500 kHz et 5 MHz.

## Patentansprüche

1. Vorrichtung mit Berührungsbildschirm (1) mit projizierter kapazitiver Erkennung, aufweisend einen Matrix-Touchscreen (10), der eine Mehrzahl von leitfähigen Leitungen (11) und leitfähigen Spalten (12) aufweist, wobei der Touchscreen mit elektronischen Befehlsmitteln (20), die für jede leitfähige Leitung und für jede leitfähige Spalte Emissionsspannungen (V_{IN}) generieren, und mit elektronischen Empfangs- und Analysemitteln (50) für die Empfangsspannungen (V_{OUT}) verbunden ist, die von jeder leitfähigen Leitung und jeder leitfähigen Spalte stammen, wobei die elektronischen Befehlsmittel angepasst sind, um für jede leitfähige Leitung und für jede leitfähige Spalte eine erste periodische Emissionsspannung, die mit einer ersten Frequenz (F_{MIN}) abgegeben wird, die als Arbeitsfrequenz bezeichnet wird, und eine zweite periodische Emissionsspannung zu generieren, die mit einer zweiten Frequenz (F_{MAX}) abgegeben wird, die als Diskriminierungsfrequenz bezeichnet wird, die sich von der ersten Frequenz unterscheidet, sodass:
bei Vorhandensein einer Berührung der schwache Wert der Arbeitsfrequenz sehr schwache Abweichungen der Empfangsspannungen auf dieser Arbeitsfrequenz verursacht, und der hohe Wert der Diskriminierungsfrequenz bedeutende Abweichungen der Empfangsspannungen in Abhängigkeit von der Position der Berührung auf der Leitung oder auf der Spalte auf dieser Diskriminierungsfrequenz verursacht;
wobei die elektronischen Empfangs- und Analysemittel (50) so angeordnet sind, dass sie für jede Leitung und für jede Spalte Folgendes bestimmen:
- den Wert einer ersten Empfangsspannung auf der Arbeitsfrequenz und den Wert einer zweiten Empfangsspannung auf der Diskriminierungsfrequenz;
- ob, in Abhängigkeit von den vorbestimmten Werten, die Werte der beiden Empfangsspannungen repräsentativ für zwei gleichzeitige Berührungen auf dem Touchscreen und die Positionsbestimmung dieser beiden Berührungen auf den beiden betreffenden Leitungen und auf den beiden betreffenden Spalten sind;
**dadurch gekennzeichnet, dass** im Fall von zwei gleichzeitigen Berührungen, wobei sich die erste Berührung an einem ersten Kreuzungspunkt einer ersten Leitung und einer ersten Spalte befindet, und sich die zweite Berührung an einem zweiten Kreuzungspunkt einer zweiten Leitung und einer zweiten Spalte befindet, die Positionsbestimmung der beiden Berührungen erfolgt mittels:
ersten Analysemitteln, die es gestatten, die Minimalwerte oder "Talwerte" der Empfangsspannungen für die erste Frequenz und die Minimalwerte oder "Talwerte" der Empfangsspannungen für die zweite Frequenz ausfindig zu machen, die den Spannungsabweichungen der beiden Berührungen entsprechen;
zweiten Analysemitteln, die es gestatten, um jede Leitung oder jede Spalte, die einem der Minimalwerte entsprechen, für eine bestimmte Anzahl von Leitungen oder Spalten, die sich zu beiden Seiten dieser Leitung oder dieser Spalte befinden, den Schwerpunkt des Spannungs-"Talwerts" zu berechnen;
dritten Analysemitteln, die es gestatten, ausgehend von der Kenntnis der Schwerpunkte die erste Leitung und die erste Spalte, die der ersten Berührung entsprechen, und die zweite Leitung und die zweite Spalte zu bestimmen, die der zweiten Berührung entsprechen.

2. Vorrichtung mit Berührungsbildschirm nach Anspruch 1, **dadurch gekennzeichnet, dass**, wenn sich die erste Leitung in der Nähe der zweiten Leitung befindet, oder wenn sich die erste Spalte in der Nähe der zweiten Spalte befindet, sodass die beiden Spannungsabweichungen, die den beiden nahe liegenden Leitungen oder den beiden nahe liegenden Spalten entsprechen, ein einziger und eindeutiger Kreuzungspunkt gebildet wird, wobei die Positionsbestimmung der beiden Berührungen ausgeführt wird mittels:
ersten Analysemitteln, die es gestatten, die "Talwerte" der Empfangsspannungen für die erste Frequenz und die "Talwerte" der Empfangsspannungen für die zweite Frequenz ausfindig zu machen, die den Spannungsabweichungen der beiden Berührungen auf den beiden benachbarten Leitungen oder den beiden benachbarten Spalten entsprechen;
zweiten Analysemitteln, die es gestatten, die Schwerpunkte der beiden Spannungs-"Talwerte" zu berechnen;
dritten Analysemitteln, die es gestatten, ausgehend von der Kenntnis der beiden Schwerpunkte die erste benachbarte Leitung und die benachbarte zweite Leitung oder die erste benachbarte Spalte und die benachbarte zweite Spalte, die der ersten Berührung oder der zweiten Berührung entsprechen, zu bestimmen.

3. Vorrichtung mit Berührungsbildschirm nach einem der vorhergehenden Ansprüche, **dadurch gekennzeichnet, dass** die elektronischen Empfangs- und Analysemittel für die Empfangsspannungen zwei synchrone Demodulatoren (53) aufweisen, wobei der erste Demodulator auf der Arbeitsfrequenz, der zweite Demodulator auf der Diskriminierungsfrequenz arbeitet.

4. Vorrichtung mit Berührungsbildschirm nach einem der vorhergehenden Ansprüche, **dadurch gekennzeichnet, dass** die elektronischen Empfangs- und Analysemittel aufweisen:
- eine Tabelle der gespeicherten Werte für die Empfangsspannungen auf der Arbeitsfrequenz jeder Leitung und jeder Spalte bei fehlender Berührung;
- Vergleichsmittel, die für jede Leitung und für jede Spalte die Unterschiede zwischen den gemessenen Werten der Empfangsspannungen und den gespeicherten Werten der Empfangsspannungen erstellen, um so zu bestimmen, ob die gemessenen Unterschiede repräsentativ für eine Berührung auf der betreffenden Leitung oder auf der betreffenden Spalte sind.

5. Vorrichtung mit Berührungsbildschirm nach einem der vorhergehenden Ansprüche, **dadurch gekennzeichnet, dass** die Arbeitsfrequenz zwischen 100 kHz und 500 kHz liegt, und dadurch, dass die Diskriminierungsfrequenz zwischen 500 kHz und 5 MHz liegt.

## Claims

1. A touchscreen device (1) with projected capacitive detection comprising a matrix touchpad (10) that comprises a plurality of conducting rows (11) and of conducting columns (12), said pad being connected to electronic control means (20) generating, for each conducting row and each conducting column, emission voltages (V_{IN}) and being connected to electronic means (50) for receiving and analysing reception voltages (V_{OUT}) coming from each conducting row and each conducting column, said electronic control means being adapted to generate, for each conducting row and each conducting column, a first periodic emission voltage emitted at a first frequency (F_{MIN}), denoted working frequency, and a second periodic emission voltage emitted at a second frequency (F_{MAX}), denoted discrimination frequency, different from said first frequency, so that:
when pressed, the low value of the working frequency causes very low variations in the reception voltages at this working frequency and the high value of the discrimination frequency causes significant variations in the reception voltages as a function of the position of the press on the row or on the column at this discrimination frequency;
said electronic reception and analysis means (50) being arranged to determine, for each row and for each column:
- the value of a first reception voltage at the working frequency and the value of a second reception voltage at the discrimination frequency;
- whether, as a function of predetermined values, the values of the two reception voltages represent two simultaneous presses on the touchpad and the location of these two presses on the two rows and two columns concerned,
**characterised in that**, in the event of two simultaneous presses, with the first press being located at a first intersection of a first row and a first column and the second press being located at a second intersection of a second row and a second column, locating the two presses is carried out by means of:
- first analysis means allowing the minima or "dips" of the reception voltages to be identified for the first frequency and the minima or "dips" of the reception voltages to be identified for the second frequency corresponding to the voltage variations of the two presses;
- second analysis means for computing, around each row or each column corresponding to one of said minima, the barycentre of the voltage "dip" for a determined number of rows or columns located either side of this row or this column;
- third analysis means for determining, on the basis of the knowledge of the barycentres, the first row and the first column corresponding to the first press and the second row and the second column corresponding to the second press.

2. The touchscreen device according to claim 1, **characterised in that**, when the first row is in the vicinity of the second row or when the first column is in the vicinity of the second column, such that the two voltage variations that correspond to the two close rows or to the two close columns form a single and unique dip, the location of the two presses is carried out by means of:
- first analysis means allowing the "dip" of the reception voltages to be identified for the first frequency and the "dip" of the reception voltages to be identified for the second frequency corresponding to the voltage variations of the two presses on the two neighbouring rows or on the two neighbouring columns;
- second analysis means allowing the barycentres of the two voltage "dips" to be computed;
- third analysis means allowing the first row and the second neighbouring row or the first column and the second neighbouring column corresponding to the first press or to the second press to be determined on the basis of the knowledge of said two barycentres.

3. The touchscreen device according to any one of the preceding claims, **characterised in that** the electronic means for receiving and analysing reception voltages comprise two synchronous demodulators (53), the first demodulator working at the working frequency, the second demodulator working at the discrimination frequency.

4. The touchscreen device according to any one of the preceding claims, **characterised in that** the electronic means for receiving and analysing comprise:
- a table of the stored values of the reception voltages at the working frequency of each row and of each column in the absence of a press;
- comparison means establishing, for each row and for each column, the differences between the measured values of the reception voltages and the stored values of the reception voltages, so as to determine whether the measured differences represent a press on the row or column concerned.

5. The touchscreen device according to any one of the preceding claims, **characterised in that** the working frequency is between 100 kHz and 500 kHz and **in that** the discrimination frequency is between 500 kHz and 5 MHz.
